# EUROPÄISCHE PATENTANMELDUNG

(11) **EP 2 339 750 A1**
(43) Veröffentlichungstag der Anmeldung: **29.06.2011**
(21) Anmeldenummer: 10015604.1
(22) Anmeldetag: 14.12.2010
(51) Int. Cl.: H03K 17/96

(54) **Kapazitiver Berührungsschalter**

(30) Priorität: 23.12.2009 DE 102009060207
(71) Anmelder: Diehl AKO Stiftung & Co. KG, 88239 Wangen (DE)
(72) Erfinder: Siebachmeyer, Fritz, 88099 Neukirch (DE)
(74) Vertreter: Diehl Patentabteilung

(57) **Zusammenfassung**

Ein kapazitiver Berührungsschalter weist einen elektrisch leitfähigen Körper (16) auf, der zwischen einer elektrisch isolierenden Abdeckplatte (10) und einer im Abstand zu dieser angeordneten Trägerplatte (14) angeordnet ist. Der elektrisch leitfähige Körper (16) ist dabei als eine auf die Trägerplatte (14) gedruckte Leiterbahn ausgebildet.

## Beschreibung

Die vorliegende Erfindung betrifft einen kapazitiven Berührungsschalter.

In vielen elektrischen bzw. elektronischen Geräten, insbesondere auch in Haushaltsgeräten wie Herden, Kochfeldern, Mikrowellenöfen, Spülmaschinen, Waschmaschinen, Wäschetrocknern und dergleichen, werden häufig berührungsempfindliche Tastschalter bzw. Berührungsschalter eingesetzt, die durch ein einfaches Berühren oder Annähern durch einen Benutzer zum Beispiel einen bestimmten Schaltvorgang auslösen und/oder eine Geräteeinstellung ändern.

Im Fall eines kapazitiven Berührungsschalters bildet ein kapazitives Sensorelement zusammen mit zum Beispiel einem Finger eines Benutzers über eine als Dielektrikum wirkende Abdeckung eine Kapazität, die entsprechend dem Betätigen des Tastschalters, d.h. dem Berühren oder Nicht-Berühren eines dem kapazitiven Sensorelement zugeordneten Berührungsfeldes der Abdeckung variabel ist. Die Veränderung des Kapazitätswertes des kapazitiven Sensorelements wirkt sich entsprechend auf ein Ausgangssignal der Sensorschaltung aus, was von der Auswerteelektronik als eine Betätigung des kapazitiven Berührungsschalters interpretiert werden kann.

Derartige kapazitive Berührungsschalter sind zum Beispiel aus der DE 10 2005 053. 792 A1 bekannt. Das kapazitive Sensorelement dieser bekannten Berührungsschalter ist durch eine Druckfeder aus einem elektrisch leitenden Material und ein Kontaktelement aus einem elektrisch leitenden Material, das auf der der Abdeckplatte zugewandten Seite der Druckfeder angeordnet und mit der Druckfeder elektrisch leitend in Kontakt ist, gebildet. In einer Variante weist das Kontaktelement eine zentrale Durchbrechung auf und ist innerhalb der Druckfeder ein Lichtleitelement angeordnet, welches mit einer Lichtquelle gekoppelt ist und der Hinterleuchtung des Berührungsfeldes des kapazitiven Berührungsschalters dient.

Die WO 2006/034993 A1 offenbart einen kapazitiven Berührungsschalter mit einer Druckfeder aus einem elektrisch leitfähigen Material, die zwischen einer elektrisch isolierenden Abdeckplatte und einer im Abstand zu dieser angeordneten Trägerplatte angeordnet ist. Das der Abdeckplatte zugewandte kapazitive Sensorelement wird durch mehrere, spiralförmig in einer Ebene liegende Windungen am Ende der Druckfeder gebildet. Auch bei diesem herkömmlichen Berührungsschalter ist die Möglichkeit vorgesehen, im Bereich innerhalb der Druckfeder eine Lichtquelle vorzusehen, um das Berührungsfeld zu kennzeichnen oder unterschiedliche Schaltzustände des Berührungsschalters zu signalisieren.

Der Erfindung liegt die Aufgabe zugrunde, einen kapazitiven Berührungsschalter mit einem sehr kompakten Aufbau zu schaffen.

Diese Aufgabe wird gelöst durch einen kapazitiven Berührungsschalter mit den Merkmalen des Anspruches 1. Vorteilhafte Ausgestaltungen und Weiterbildungen der Erfindung sind Gegenstand der abhängigen Ansprüche.

Der kapazitive Berührungsschalter der Erfindung weist einen elektrisch leitfähigen Körper auf, der zwischen einer elektrisch isolierenden Abdeckplatte und einer im Abstand zu dieser angeordneten Trägerplatte angeordnet ist, und ist dadurch gekennzeichnet, dass der elektrisch leitfähige Körper als eine auf die Trägerplatte gedruckte Leiterbahn ausgebildet ist.

Erfindungsgemäß ist vorgesehen, dass der elektrisch leitfähige Körper als eine auf die Trägerplatte gedruckte Leiterbahn ausgebildet ist. Aufgrund dieser sehr platzsparenden Konstruktion des elektrisch leitfähigen Körpers kann die Trägerplatte in einem sehr geringen Abstand zur Abdeckplatte angeordnet werden. Hierdurch benötigen Trägerplatte und kapazitives Sensorelement insgesamt sehr wenig Bauraum hinter der Abdeckplatte.

Da der elektrisch leitfähige Körper des kapazitiven Sensorelements mittels eines Bedruckungsverfahrens oder dergleichen hergestellt werden kann, kann er in seiner Form nahezu beliebig gestaltet werden. So kann er beliebige Formen und Größen der Berührungsfelder auf der Bedienseite der Abdeckplatte problemlos nachbilden.

Der elektrisch leitfähige Körper bildet das kapazitive Sensorelement, welches zusammen mit zum Beispiel einem Finger eines Benutzers über die als Dielektrikum wirkende Abdeckplatte eine Kapazität bildet, die entsprechend dem Berühren oder Nicht-Berühren eines dem kapazitiven Sensorelement zugeordneten Berührungsfeldes der Abdeckplatte variabel ist.

Die Trägerplatte kann zum Beispiel eine Leiterplatte mit einer aufgedruckten Leiterbahn oder eine Kunststoffplatte mit einem Leitlack-Aufdruck sein. Die Trägerplatte kann als stabiler Plattenkörper ausgebildet sein oder nur Folienstärke aufweisen.

In einer Ausgestaltung der Erfindung kontaktiert die Leiterbahn die der Trägerplatte zugewandte Seite der Abdeckplatte. In einer anderen Ausgestaltung der Erfindung kann die Leiterbahn auch in einem Abstand zur Abdeckplatte angeordnet sein.

In einer Ausführungsform ist die Leiterbahn flächig ausgebildet. Die Leiterbahn bildet somit auf der Trägerplatte eine gefüllte Fläche einer grundsätzlich beliebigen Form (z.B. Kreis, Ellipse, Rechteck, etc.).

In einer alternativen Ausführungsform ist die Leiterbahn in Form eines geschlossenen oder offenen Ringes mit freier Innenfläche ausgebildet. Die Leiterbahn hat eine grundsätzlich beliebige Form (z.B. Kreis, Ellipse, Rechteck, etc.), besitzt aber im Gegensatz zur flächigen Ausbildung eine freie, d.h. elektrisch nicht leitfähige Innenfläche grundsätzlich beliebiger Form. Dabei kann die freie Innenfläche wahlweise die gleiche oder eine andere geometrische Form als die Leiterbahn (bzw. deren Außenumfang) besitzen. Die ringförmig gestaltete Leiterbahn kann ferner wahlweise geschlossen oder offen, d.h. mit wenigstens einer elektrisch nicht leitfähigen Unterbrechung, ausgestaltet sein.

Die Grundform der Leiterbahn, d.h. insbesondere deren Umriss, bestimmt gleichzeitig die Form des Berührungsfeldes auf der Abdeckplatte, das dem kapazitiven Sensorelement zugeordnet ist.

Im Fall einer ringförmig gestalteten Leiterbahn kann in einer weiteren Ausgestaltung die Abdeckplatte im Bereich der freien Innenfläche der Leiterbahn zumindest teilweise lichtdurchlässig ausgebildet sein, die Trägerplatte im Bereich der freien Innenfläche der Leiterbahn eine Durchbrechung aufweisen und ein Lichtleitelement vorgesehen sein, welches in der Durchbrechung in der Trägerplatte angeordnet ist und mit wenigstens einer Lichtquelle gekoppelt ist. Bei dieser Ausgestaltung besteht die Möglichkeit, das dem kapazitiven Sensorelement zugeordnete Berührungsfeld auf der Abdeckplatte zu hinterleuchten bzw. zu kennzeichnen und/oder einen Schaltzustand des kapazitiven Berührungsschalters zu signalisieren.

Hierbei kann die wenigstens eine Lichtquelle, zum Beispiel eine Leuchtdiode, auf der Abdeckplatte abgewandten Seite der Trägerplatte angeordnet sein.

Vorzugsweise kontaktiert das Lichtleitelement die der Trägerplatte zugewandte Seite der Abdeckplatte. Hierdurch können die Strahlungsverluste von der Lichtquelle bis zur Abdeckplatte minimiert werden.

Ferner kann das Lichtleitelement auf der der Abdeckplatte abgewandten Seite der Trägerplatte über die Trägerplatte vorstehen und die Durchbrechung in wenigstens einer Richtung überragen. Auf diese Weise kann die Kopplung des Lichtleitelements mit der wenigstens einen Lichtquelle vereinfacht werden. Außerdem kann die positionsgenaue und feste Montage des Lichtleitelements in der Durchbrechung der Trägerplatte gewährleistet werden.

In einer weiteren Ausgestaltung der Erfindung ist die Trägerplatte zumindest teilweise als eine flexible Trägerplatte ausgebildet. Hierdurch können Bauteiltoleranzen ausgeglichen werden oder die Trägerplatte an den Verlauf einer gekrümmten Abdeckplatte angepasst werden.

In einer noch weiteren Ausgestaltung der Erfindung ist ein Druckelement vorgesehen, welches die Trägerplatte im Bereich der Leiterbahn in Richtung zur Abdeckplatte drückt. Hierdurch kann ein geringer Abstand bzw. eine Kontaktierung zwischen der Abdeckplatte und der Leiterbahn gewährleistet werden, wodurch die sichere Funktionsfähigkeit des kapazitiven Sensorelements gewährleistet werden kann. Dies gilt insbesondere auch im Fall von temperatur-oder alterungsbedingten Veränderungen der Bauteile und deren Verbindungen.

Obige sowie weitere Merkmale, Vorteile und Anwendungsmöglichkeiten der Erfindung werden aus der nachfolgenden Beschreibung bevorzugter, nichteinschränkender Ausführungsbeispiele unter Bezugnahme auf die beiliegenden Zeichnungen besser verständlich. Darin zeigen:
- Fig. 1: eine schematische Querschnittsansicht eines kapazitiven Berührungsschalters gemäß einem ersten Ausführungsbeispiel der vorliegenden Erfindung;
- Fig. 2: mehrere schematische Darstellungen zum Erläutern verschiedener Grundformen des elektrisch leitfähigen Körpers des kapazitiven Berührungsschalters von Fig. 1 bzw. 3; und
- Fig. 3: eine schematische Querschnittsansicht eines kapazitiven Berührungsschalters gemäß einem zweiten Ausführungsbeispiel der vorliegenden Erfindung.

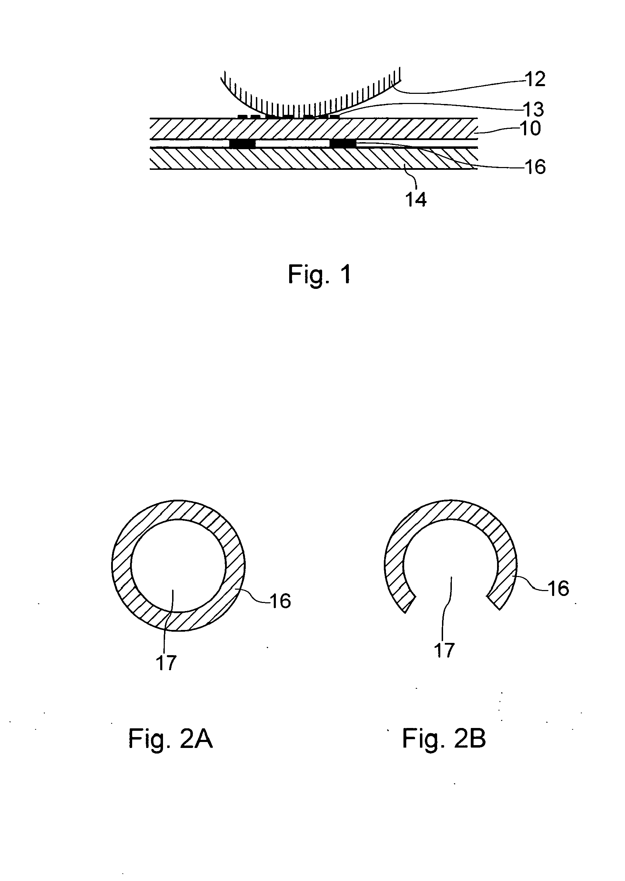

In Fig. 1 ist zunächst die Grundform eines kapazitiven Berührungsschalters als ein erstes Ausführungsbeispiel veranschaulicht.

Hinter einer Abdeckplatte 10, die zum Beispiel Teil einer Bedienblende eines Haushaltsgeräts ist oder in eine solche integriert ist, ist ein kapazitives Sensorelement angeordnet. Die Abdeckplatte 10 ist aus einem elektrisch isolierenden Material wie zum Beispiel aus Glas, Glaskeramik oder Kunststoff gefertigt, sodass sie in bekannter Weise als ein Dielektrikum des kapazitiven Berührungsschalters dienen kann.

Auf der dem Benutzer zugewandten Seite der Abdeckplatte 10 (oben in Fig. 1) ist ein Berührungsfeld 13 vorgesehen, welches von einem Benutzer mit dem Finger 12 berührt werden kann. Dieses Berührungsfeld 13 ist vorzugsweise in irgendeiner Weise gekennzeichnet.

Auf der dem Benutzer abgewandten Seite der Abdeckplatte 10 (unten in Fig. 1) ist mit einem Abstand zu dieser eine Leiterplatte 14 angeordnet. Diese Leiterplatte 14 trägt die Sensorschaltung und die Auswerteelektronik. Außerdem kann sie Teil der Steuerung des Haushaltsgeräts sein oder mit dieser über entsprechende Kabelverbindungen verbunden sein.

Zum Ausbilden des kapazitiven Sensorelements ist zwischen der Abdeckplatte 10 und der Leiterplatte 14 ein elektrisch leitfähiger Körper in Form einer auf die Leiterplatte 14 gedruckten Leiterbahn 16 angeordnet. Diese Leiterbahn 16 benötigt nur wenig Bauraum, sodass die Leiterplatte 16 relativ nahe hinter der Abdeckplatte 10 angeordnet werden kann.

In dem Ausführungsbeispiel von Fig. 1 steht die Leiterbahn 16 in direktem Kontakt mit der Abdeckplatte 10. Alternativ ist es auch möglich, zwischen der Leiterbahn 16 und der der Leiterplatte 14 zugewandten Seite der Abdeckplatte 10 einen kleinen Abstand bzw. Spalt zu lassen.

Die Leiterplatte 14 ist üblicherweise als starre Leiterplatte ausgebildet. Es ist aber ebenso möglich, flexible oder zumindest teilweise flexible Leiterplatten 14 zu verwenden, um Bauteiltoleranzen auszugleichen oder eine Anpassung an eine gekrümmte Abdeckplatte 10 zu ermöglichen.

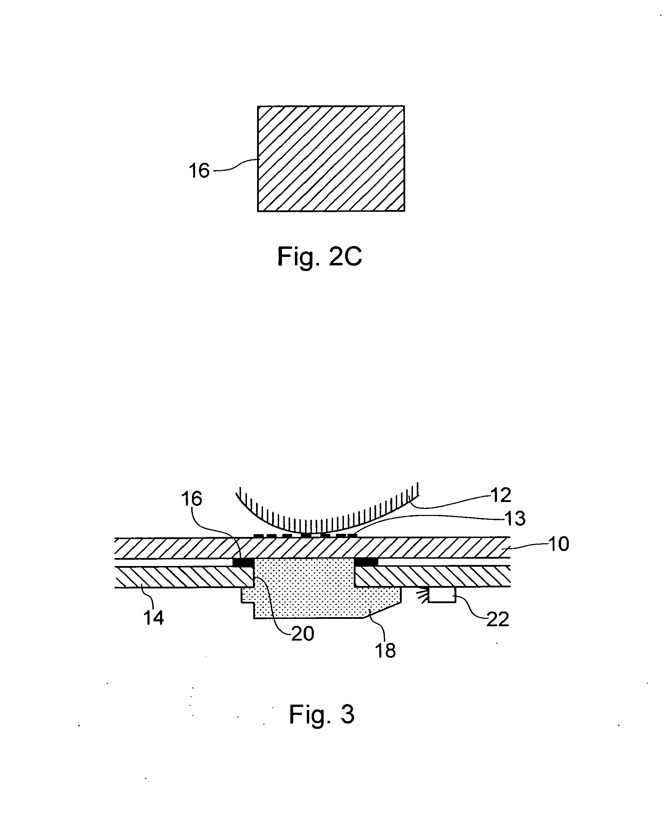

Wie in Fig. 2 beispielhaft veranschaulicht, kann die Leiterbahn 16 in Draufsicht wahlweise in Form eines geschlossenen Ringes (Darstellung A), eines offenen Ringes (Darstellung B) oder einer geschlossenen Fläche (Darstellung C) ausgebildet sein.

Im Fall der ringförmigen Leiterbahnen 16 ist eine freie Innenfläche 17 vorhanden. Der Bereich der freien Innenfläche 17 ist nicht elektrisch leitfähig ausgebildet, insbesondere nicht mit einer Leiterbahn versehen. Die offene Ringform kann wahlweise durch eine oder mehrere Unterbrechungen der ringförmigen Leiterbahn 16 gebildet sein.

Die Grundform dieser verschiedenen Varianten der Leiterbahn 16 ist grundsätzlich beliebig. Insbesondere sind kreisförmige, ellipsenförmige, quadratische und rechteckige Formen denkbar. Grundform und Größe der Leiterbahn 16 bestimmen gleichzeitig Form und Größe des Berührungsfeldes 13 auf der Abdeckplatte 10, die dem kapazitiven Sensorelement zugeordnet ist.

Bezug nehmend auf Fig. 3 wird nun ein zweites Ausführungsbeispiel eines kapazitiven Berührungsschalters näher erläutert. Dabei sind gleiche oder ähnliche Komponenten mit den gleichen Bezugsziffern wie im ersten Ausführungsbeispiel gekennzeichnet.

Wie im ersten Ausführungsbeispiel von Fig. 1 ist hinter der elektrisch isolierenden Abdeckplatte 10 eine Leiterplatte 14 mit einer aufgedruckten Leiterbahn 16 als kapazitives Sensorelement angeordnet. Die Leiterbahn 16 ist in diesem Fall ringförmig ausgebildet (vgl. Fig. 2A und 2B).

Im Unterschied zur Ausführungsform von Fig. 1 weist die Leiterplatte 16 in diesem Ausführungsbeispiel eine Durchbrechung 20 auf, welche im Bereich der freien Innenfläche 17 der ringförmigen Leiterbahn 16 vorgesehen ist. Die Durchbrechung 20 kann dabei wahlweise genauso groß wie oder kleiner als die freie Innenfläche 17 gebildet sind. Außerdem kann die Durchbrechung 20 wahlweise die gleiche oder eine andere Form als die freie Innenfläche 17 innerhalb der Leiterbahn 16 haben.

In dieser Durchbrechung 20 der Leiterplatte 14 ist ein Lichtleitelement 18 angeordnet. Das Lichtleitelement 18 ist vorzugsweise passgenau in die Durchbrechung 20 eingesetzt:
Ferner ist das Lichtleitelement 18 vorzugsweise so gestaltet, dass es die Durchbrechung 20 der Leiterplatte 14 in Richtung zur Abdeckung 10 hin durchragt,
sodass es mit der der Leiterplatte 14 zugewandten Seite der Abdeckplatte 10 in Kontakt steht. Auf diese Weise entsteht eine gute Kopplung mit minimalen Strahlungsverlusten zwischen dem Lichtleitelement 18 und der Abdeckplatte 10.

Die Abdeckplatte 10 ist in dem Bereich der freien Innenfläche 17 der ringförmigen Leiterbahn 16 zumindest teilweise lichtdurchlässig ausgebildet. Dabei kann sich die Lichtdurchlässigkeit der Abdeckplatte 10 wahlweise auch über die freie Innenfläche 17 oder sogar über die Leiterbahn 16 hinaus erstrecken.

Das Lichtleitelement 18 ist weiter so ausgebildet, dass es die Durchbrechung 20 der Leiterplatte 14 auch in Richtung weg von der Abdeckung 10 durchragt. Wie in Fig. 3 dargestellt, erstreckt sich das Lichtleitelement 18 dabei auf der der Abdeckung 10 abgewandten Seite der Leiterplatte 16 zumindest teilweise über die Durchbrechung 20 hinaus. Auf diese Weise kann eine genaue und zuverlässige Positionierung des Lichtleitelements 18 gewährleistet werden.

Auf der der Abdeckung 10 abgewandten Seite der Leiterplatte 16 ist zudem wenigstens eine Lichtquelle 22, zum Beispiel eine LED, vorgesehen. Diese wenigstens eine Lichtquelle 22 ist (seitlich) mit dem Lichtleitelement 18 gekoppelt, sodass das von dieser Lichtquelle 22 ausgesendete Licht durch das Lichtleitelement 18 zur lichtdurchlässigen Abdeckung 10 geleitet wird.

Bei diesem Ausführungsbeispiel kann die Berührungsfläche auf der Abdeckplatte 10 für den Benutzer hinterleuchtet und damit gekennzeichnet werden. Außerdem besteht die Möglichkeit, den Schaltzustand des Berührungsschalters zu signalisieren, zum Beispiel anhand der Farbe der Lichtquelle 22 oder des Einschaltzustandes (ein, aus, blinkend) der Lichtquelle 22.

Obwohl in Fig. 1 und 3 nicht dargestellt, kann in beiden Ausführungsbeispielen zusätzlich ein Druckelement vorgesehen sein, welches die Leiterplatte im Bereich der Leiterbahn 16 in Richtung zur Abdeckplatte 10 hin drückt.

Auf diese Weise wird ein minimaler Abstand bzw. eine Kontaktierung zwischen der Leiterbahn 16 als dem kapazitiven Sensorelement und der Abdeckplatte 10 als dem Dielektrikum gewährleistet. Hierdurch kann eine zuverlässige Funktionsweise des kapazitiven Berührungsschalters erreicht werden.

Mit Hilfe eines solchen Druckelements können zudem Bauteiltoleranzen ausgeglichen werden, Maßänderungen aufgrund von Temperaturschwankungen oder Alterungserscheinungen ausgeglichen werden und/oder eine dauerhaft sichere Montage der Leiterplatte 16 erreicht werden.

Während in den oben beschriebenen Ausführungsbeispielen die Leiterbahn 16 jeweils auf eine Leiterplatte aufgedruckt ist, ist die Erfindung nicht nur auf diese Ausführungsform beschränkt. So kann als Trägerplatte 14 für die Leiterbahn 16 zum Beispiel auch ein Kunststoffteil verwendet werden, auf welches ein Leitlack-Aufdruck aufgebracht wird.

### BEZUGSZIFFERNLISTE

- 10: Abdeckplatte
- 12: Finger eines Benutzers
- 13: Berührungsfeld
- 14: Trägerplatte
- 16: Leiterbahn
- 17: freie Innenfläche der Leiterbahn
- 18: Lichtleitelement
- 20: Durchbrechung in 14
- 22: Lichtquelle

## Patentansprüche

1. Kapazitiver Berührungsschalter, mit einem elektrisch leitfähigen Körper (16), der zwischen einer elektrisch isolierenden Abdeckplatte (10) und einer im Abstand zu dieser angeordneten Trägerplatte (14) angeordnet ist,
**dadurch gekennzeichnet,**
**dass** der elektrisch leitfähige Körper (16) als eine auf die Trägerplatte (14) gedruckte Leiterbahn ausgebildet ist.

2. Kapazitiver Berührungsschalter nach Anspruch 1,
**dadurch gekennzeichnet,**
**dass** die Leiterbahn (16) die der Trägerplatte (14) zugewandte Seite der Abdeckplatte (10) kontaktiert.

3. Kapazitiver Berührungsschalter nach Anspruch 1 oder 2,
**dadurch gekennzeichnet,**
**dass** die Leiterbahn (16) flächig ausgebildet ist.

4. Kapazitiver Berührungsschalter nach Anspruch 1 oder 2,
**dadurch gekennzeichnet,**
**dass** die Leiterbahn (16) in Form eines geschlossenen oder offenen Ringes mit freier Innenfläche (17) ausgebildet ist.

5. Kapazitiver Berührungsschalter nach Anspruch 4,
**dadurch gekennzeichnet,**
**dass** die Abdeckplatte (10) im Bereich der freien Innenfläche (17) der Leiterbahn (16) zumindest teilweise lichtdurchlässig ausgebildet ist;
**dass** die Trägerplatte (14) im Bereich der freien Innenfläche (17) der Leiterbahn (16) eine Durchbrechung (20) aufweist; und
**dass** in der Durchbrechung (20) der Trägerplatte (14) ein Lichtleitelement (18) angeordnet ist, welches mit wenigstens einer Lichtquelle (22) gekoppelt ist.

6. Kapazitiver Berührungsschalter nach Anspruch 5,
**dadurch gekennzeichnet,**
**dass** die wenigstens eine Lichtquelle (22) auf der Abdeckplatte (10) abgewandten Seite der Trägerplatte (14) angeordnet ist.

7. Kapazitiver Berührungsschalter nach Anspruch 5 oder 6,
**dadurch gekennzeichnet,**
**dass** das Lichtleitelement (18) die der Trägerplatte (14) zugewandte Seite der Abdeckplatte (10) kontaktiert.

8. Kapazitiver Berührungsschalter nach einem der Ansprüche 5 bis 7,
**dadurch gekennzeichnet,**
**dass** das Lichtleitelement auf der der Abdeckplatte (10) abgewandten Seite der Trägerplatte (14) über die Trägerplatte (14) vorsteht und die Durchbrechung (20) in wenigstens einer Richtung überragt.

9. Kapazitiver Berührungsschatter nach einem der vorherigen Ansprüche, **dadurch gekennzeichnet,**
**dass** die Trägerplatte (14) zumindest teilweise als eine flexible Trägerplatte ausgebildet ist.

10. Kapazitiver Berührungsschalter nach einem der vorherigen Ansprüche, **dadurch gekennzeichnet,**
**dass** ein Druckelement vorgesehen ist, welches die Trägerplatte (14) im Bereich der Leiterbahn (16) in Richtung zur Abdeckplatte (10) drückt.
